# EUROPÄISCHE PATENTSCHRIFT

(11) **EP 1 284 037 B1**
(45) Veröffentlichungstag und Bekanntmachung des Hinweises auf die Patenterteilung: **18.04.2007**
(21) Anmeldenummer: 00990571.2
(22) Anmeldetag: 22.12.2000
(51) Int. Cl.: H01S 5/223

(54) **STREIFENLASERDIODENELEMENT**
STRIPE LASER DIODE ELEMENT
ELEMENT A DIODE LASER A GEOMETRIE EN RUBAN

(30) Priorität: 30.12.1999 DE 19963807
(43) Veröffentlichungstag der Anmeldung: 19.02.2003
(73) Patentinhaber: Osram Opto Semiconductors GmbH, 93049 Regensburg (DE)
(72) Erfinder: GRUBER, Stefan, 93077 Bad Abbach (DE); HEERLEIN, Jörg, 93051 Regensburg (DE); UNGER, Peter, 89075 Ulm (DE)
(74) Vertreter: Epping - Hermann - Fischer
(86) Internationale Anmeldenummer: PCT/DE2000/004592
(87) Internationale Veröffentlichungsnummer: WO 2001/050553

(56) Entgegenhaltungen:
- US-A- 5 963 573
- PATENT ABSTRACTS OF JAPAN vol. 014, no. 408 (E-0972), 4. September 1990 (1990-09-04) & JP 02 154493 A (NEC CORP), 13. Juni 1990 (1990-06-13)
- PATENT ABSTRACTS OF JAPAN vol. 012, no. 244 (E-631), 9. Juli 1988 (1988-07-09) & JP 63 032978 A (MITSUBISHI ELECTRIC CORP), 12. Februar 1988 (1988-02-12)
- HEERLEIN J ET AL: "SINGLE-MODE ALGAAS-GAAS LASERS USING LATERAL CONFINEMENT BY NATIVE-OXIDE LAYERS" IEEE PHOTONICS TECHNOLOGY LETTERS,US,IEEE INC. NEW YORK, Bd. 10, Nr. 4, 1. April 1998 (1998-04-01), Seiten 498-500, XP000754206 ISSN: 1041-1135
- OHNOKI N ET AL: "GAINAS/ALGAINAS SEMICONDUCTOR LASERS WITH ALAS OSIDE CONFINEMENT STRUCTURE" JAPANESE JOURNAL OF APPLIED PHYSICS,JP,PUBLICATION OFFICE JAPANESE JOURNAL OF APPLIED PHYSICS. TOKYO, Bd. 36, Nr. 3B, PART 01, 1. März 1997 (1997-03-01), Seiten 1896-1899, XP000703122 ISSN: 0021-4922

## Beschreibung

Die Erfindung betrifft ein Streifenlaserdiodenelement gemäß dem Oberbegriff des Patentanspruchs 1.

Aus J. Heerlein, R. Jäger und P. Unger, Single-Mode AlGaAs-GaAs Lasers using Laterad confinement by Native-Oxide Layers, IEEE photonics technology letters, vol. 10, No.1, April 1997, Seite 498-500, ist eine bekannte Struktur eines Streifenlaserdiodenelementes beschrieben. Bei der beschriebenen Struktur wird auf einem GaAs-Substrat eine n-dotierte AlGaAs-Umhüllungs- bzw. "Cladding"-Schicht aufgetragen. Darüber ist eine AlAs-Schicht aufgetragen, wobei dazwischen der aktive Bereich der Laserdiode ausgebildet ist. In diesem aktiven Bereich wird durch Einprägen eines Stromes das Laserlicht erzeugt. Auf der AlAs-Schicht wird eine p-dotierte AlGaAs-Abdeck- bzw. "Cladding"-Schicht aufgetragen. Darauf ist ein Kontakt aufgesetzt, um einen Strom einprägen zu können. Um eine Stromaufweitung in diesem in üblicher Weise aufgebauten Laserelement zu vermeiden, ist durch die oberen Schichten ein Graben 90 mittels Ätzverfahren eingebracht, der bis zur AlAs-Schicht reicht. Der Abstand zweier Gräben 90 macht die Breite eines Laserstreifens 100 (Streifenlaserdiodenelementes) aus. Mittels Wasserdampf-Oxidation wird die AlAs-Schicht von den Gräben 90 her zur Mitte der Streifen hin oxidiert. Diese oxidierten Bereiche stellen eine Blende dar, die den Strompfad durch das Bauelement einschränkt und die zuvor genannte Stromaufweitung verhindert. Obwohl die laterale Wellenführung mit Hilfe der Oxidblende eingestellt wird, wurde bei der beschriebenen Anordnung beobachtet, daß an den Flanken der Gräben 90 unerwünschte seitliche Reflexionen auftreten. Diese verschlechtern in einigen Betriebsbereichen die Strahlungsqualität erheblich.

Aufgabe der Erfindung ist es demgemäß, eine Streifenlaserdiodenanordnung der zuvor geschriebenen Art derart zu verbessern, daß mit einfachen Mitteln das zuvor erwähnte Auftreten von Reflektionen an den seitlichen Rändern weitestgehend verhindert ist.

Diese Aufgabe wird erfindungsgemäß mit den im Patentanspruch 1 angegebenen Maßnahmen gelöst.

Durch das Vorsehen einer Absorptionszone im Bereich der Flanken wird das hier seitlich einfallende und nicht in der Abstrahlrichtung des Lasers sich ausbreitende Licht absorbiert, wodurch die Reflexion weitestgehend verhindert wird.

Weitere vorteilhafte Ausgestaltung der Erfindung sind in den untergeordneten Patentansprüchen angegeben. Dadurch, dass die Absorptionszone orthogonal zur Längsausbreitungsrichtung und Stromrichtung eine sich änderhde Absorptionsstärke aufweist, wird eine abrupte durch die Absorptionszone verursachte Änderung des Brechungsindexes verhindert, wodurch das Auftreten von Reflexionen weiterhin vermieden wird.

Das Auftragen einer Absorptionsschicht auf den Flanken ermöglicht ein sehr einfaches Herstellen der Absorptionszone. Durch das Ausbilden der Absorptionszone mittels Implantation wird die Absorptionszone durch ein bekanntes sich selbst justierendes Verfahren erzeugt, was die Herstellung der Absorbtionszone ebenfalls stark vereinfacht.

Dadurch, daß die Flanken von der Oberfläche weg in einem stumpfen Winkel zu dieser laufen, kommt es ebenfalls zu einem quer zur Längsausbreitungsrichtung variierenden Absorptionsgrad der Absorptionschicht, wodurch ebenfalls das Auftreten von Reflexionen weiter vermindert ist.

Nachfolgend wird die Erfindung unter Bezugnahme auf die Zeichnung anhand von Ausführungsbeispielen erläutert.

Es zeigen:
- Fig.1: eine Perspektivansicht eines erfindungsgemäßen Ausführungsbeispiels eines Streifenlaserdiodenelementes,
- Fig.2: das erste Ausführungsbeispiel im Schnitt,
- Fig.3: ein zweites erfindungsgemäßes Ausführungsbeispiel,
- Fig.4: ein drittes erfindungsgemäßes Ausführungsbeispiel und
- Fig.5: ein viertes erfindungsgemäßes Ausführungsbeispiel.

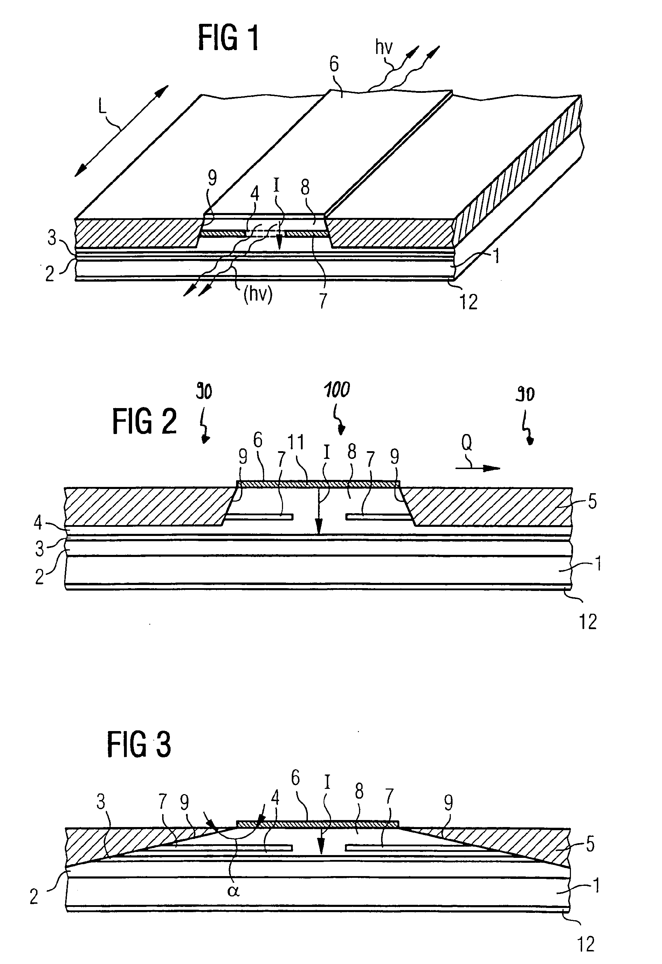

Fig.1 zeigt in einer Perspektivansicht den grundsätzlichen Aufbau des ersten erfindungsgemäßen Ausführungsbeispieles des Laserdiodenelementes, wobei weitere Elemente in Figur 2 dargestellt sind und unter Bezugnahme auf diese erläutert werden.

Nachfolgend wird zum besseren Verständnis der dargestellten Struktur das grundsätzliche Herstellungsverfahren der dargestellten Struktur erläutert. Auf einem Substrat 1, das aus GaAs hergestellt ist, wird eine n-dotierte AlGaAs-Schicht 2 aufgetragen. Darüber befindet sich eine AlAs-Schicht 4, wodurch sich zwischen der Schicht 4 und der Schicht 2 eine aktive Zone 3 ausbildet. Auf die Schicht 4 wird eine p-dotierte AlGaAs-Schicht 8 aufgetragen, die wiederum von einem Kontakt 6 abgedeckt wird. Grundsätzlich ist damit der Aufbau einer Laserdiode hergestellt. Der Strom zur Einstellung der Besetzungsinversion fließt zwischen den Kontakten 6 und 12, wobei das Laserlicht in der aktiven Zone 3 erzeugt wird. Lichtwellen des Laserlichtes bilden sich in Richtung einer Längsausbreitungsrichtung L aus. Auf die exakte Beschreibung einer Laserdiode wird an dieser Stelle verzichtet und deren Kenntnis als für den Fachmann selbstverständlich vorausgesetzt. Um den Strompfad und damit das Gebiet, in dem das Laserlicht entsteht, quer zur Längsausbreitungsrichtung L einzuschränken, werden, bevor die Kontakte 6 und 12 aufgebracht werden, parallele Gräben 90 in Richtung der Längsausbreitungsrichtung L mittels eines Ätzverfahrens eingebracht.

Mittels eines Oxidationsprozesses wird ausgehend von den Flanken 9 des entstandenen Laserstreifens, die AlAs-Schicht 4 in der Form oxidiert, daß sich von den Flanken 9 weg Blenden 7 ausbilden. Durch die Öffnung der Blende 7, wird der Strom in Richtung I zwischen den Kontakten auf einen sehr engen Bereich eingegrenzt.

Um die optische Welle transversal zur Ausbreitungsrichtung zu führen, ist die aktive Zone zusammen mit der AlAs-Schicht 4 von n- bzw. p-dotierten AlGaAs-Zonen 8 bzw. 2 umgeben. Diese Schichten dienen dazu, daß das Laserlicht in der Schicht 4, die im weiteren als Wellenleiterschicht 4 bezeichnet wird, gehalten wird. Die beiden Schichten 2 und 8 sind im weiteren als obere Deckschicht 8 und untere Deckschicht 2 bezeichnet.

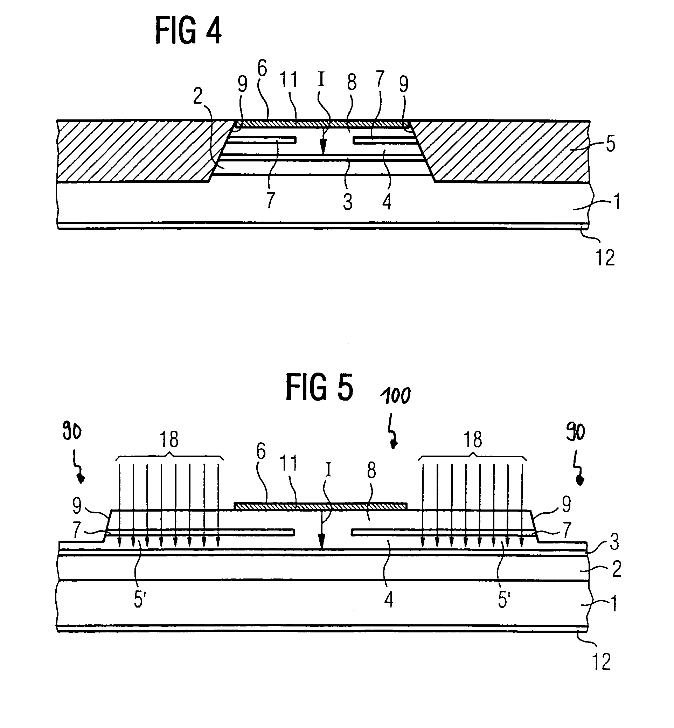

Um das in der Beschreibungseinleitung erläuterte Auftreten von Streulicht durch Reflexion an den Flanken 9 weitestgehend zu verhindern, wird der Graben 90 mit einer absorbierenden Schicht aufgefüllt, die z. B. aus Si und/oder Ge besteht. Diese Schicht 5 dient der Absorption und ist im nachfolgenden als Absorptionsschicht 5 bezeichnet. Durch die Absorption dieser Schicht wird die Reflexion an den Flanken 9 des Laserstreifens weitestgehend verhindert. Um dies noch weiter verbessern zu können, wird die laterale Absorptionsstärke der Absorptionsschicht 5 quer zur Längsausbreitungsrichtung L verändert. Dies wird beispielsweise im Ausführungsbeispiel, wie es in Fig.2 dargestellt ist, durch ein sich veränderndes Si/Ge-Verhältnis in Richtung Q eingestellt. Im Ausführungsbeispiel gemäß Fig.3, wird dies hingegen durch sehr flache Flanken 9 erzeugt, entsprechend einem stumpfen Winkel α an der Oberfläche 11 zum Kontakt 6. Das zweite, dritte und vierte Ausführungsbeispiel gemäß Fig.3, 4 und 5 unterscheiden sich desweiteren in unterschiedlich tiefen Gräben 90. Im ersten Ausführungsbeispiel befindet sich der Graben 90 und damit die Absorptionsschicht 5 nur im Bereich der oberen Abdeckschicht 8. Dem gegenüber ist sowohl im zweiten Ausführungsbeispiel als auch im dritten Ausführungsbeispiel nach Fig.4 der Graben 90 bis unter die aktive Zone 3 oder in das Substrat 1 eingebracht.

Im vierten Ausführungsbeispiel gemäß Fig.5 wird die Absorptionszone 5' wie folgt erzeugt. Die Struktur ist im wesentlichen die selbe wie bei den vorangegangenen Ausführungsbeispielen, wobei gleiche Bezugszeichen gleiche Elemente bezeichnen. Bei dem in Fig.5 dargestellten Ausführungsbeispiel ist der Kontakt 6 auf der Oberfläche 11 nicht bis an die Flanken 9 herangeführt. Auf diese Weise kann mittels Ionenimplantation 18 unterhalb der Blenden 7 die Absorbtionzone 5' erzeugt werden. Der Kontakt 6 wird dabei zum Justieren der Implantation benutzt, wodurch sich ein automatisch selbstjustierendes Verfahren ergibt. Die Implantation kann dabei so eingestellt werden, daß ein quer zur Längsausbreitungsrichtung L veränderndes Absorbtionsprofil erzeugt ist.

Selbstverständlich kann das vierte Ausführungsbeispiel mit den zuvor dargestellten Ausführungsbeispielen kombiniert werden.

Es wird darauf hingewiesen, daß die Erfindung im wesentlichen auf das Vorsehen der Absorbtionszone 5 bzw. 5' ausgerichtet ist und diese auch bei anderen Streifenlaseranordnungen, die von der dargestellten Schichtfolge abweichen, anwendbar sind.

## Patentansprüche

1. Streifenlaserdiodenelement, das in Hauptausbreitungsrichtung eines Laserlichtes (hv) auf einer Oberseite (11) ein Kontaktelement (6) aufweist, um einen Strom (I) zum Betreiben des Streifenlaserdiodenelementes einzuprägen, und dessen Oberseite (11) quer zur Längsausbreitungsrichtung (L) durch Gräben (90) begrenzt ist, die sich einerseits entlang zur Längsausbreitungsrichtung (L) und andererseits in Richtung zum Substrat (1) hin erstrecken, auf den das Streifenlaserdiodenelement aufgebaut ist, und Flanken (9) des Laserstreifens (100) erzeugen, von denen sich Strombegrenzungsblenden, die als oxidente Bereiche ausgebildet sind, in den Lagerstufen erstrechen,
**dadurch gekennzeichnet,**
**daß** eine Strahlungs-Absorptionszone (5; 5') im Bereich der Flanken (9) ausgebildet ist,
wobei das Auftreten von Stranhlungsreflexionen an den Flankens weitestgehend verhindert wird.

2. Streifenlaserdiodenelement nach Anspruch 1,
**dadurch gekennzeichnet,**
**daß** die Absorbtionszone (5) als Absorbtionschicht in den Gräben (90) ausgebildet ist.

3. Streifenlaserdiodenelement nach einem der Ansprüche 1 und 2,
**dadurch gekennzeichnet,**
**daß** die Absorbtionszone (5; 5') in einer Richtung orthogonal zur Längsausbreitungsrichtung (L) und zur Stromrichtung (I) eine veränderliche Absorbtionsstärke aufweist.

4. Streifenlaserdiodenelement nach einem der Ansprüche 1 bis 3,
**dadurch gekennzeichnet,**
**daß** die Absorptionszone (5') durch Ionenimplantation in den Laserstreifen im Bereich der Flanken (9) erzeugt ist.

5. Streifenlaserdiodenelement nach einem der vorhergehenden Ansprüche, **dadurch gekennzeichnet**
**daß** sich die Flanken (9) von der Oberfläche (11) weg in einem stumpfen Winkel (α) ausbreiten.

6. Streifenlaserdiodenelement nach einem der vorhergehenden Ansprüche,
**dadurch gekennzeichnet,**
**daß** die Absorptionszone (5; 5') aus Si und/oder Ge besteht.

## Claims

1. Stripe laser diode element which comprises a contact element (6) on an upper side (11) in the propagation direction of laser light (hv) in order to impose a current (I) for operating the stripe laser diode element, and whose upper side (11) is bounded transversely to the longitudinal propagation direction (L) by trenches (90) which extend on the one hand along the longitudinal propagation direction (L) and on the other hand in the direction of the substrate (1) on which the stripe laser diode element is constructed, and which form sidewalls (9) of the laser stripe (100) from which current limiting masks formed as oxidized regions extend into the laser stripe, **characterized in that** a radiation absorption zone (5; 5') is formed in the region of the sidewalls (9), the occurrence of radiation reflections by the sidewalls being substantially prevented.

2. Stripe laser diode element according to Claim 1, **characterized in that** the absorption zone (5) is formed as an absorption layer in the trenches (90).

3. Stripe laser diode element according to one of Claims 1 and 2, **characterized in that** the absorption zone (5; 5') has a variable absorption strength in a direction orthogonal to the longitudinal propagation direction (L) and to the current direction (I).

4. Stripe laser diode element according to one of Claims 1 to 3, **characterized in that** the absorption zone (5') is formed by ion implantation in the laser stripe in the region of the sidewalls (9).

5. Stripe laser diode element according to one of the preceding claims, **characterized in that** the sidewalls (9) extend at an obtuse angle (α) away from the surface (11).

6. Stripe laser diode element according to one of the preceding claims, **characterized in that** the absorption zone (5; 5') consists of Si and/or Ge.

## Revendications

1. Elément à diode laser à géométrie en ruban qui, dans la direction principale de propagation d'une lumière laser (hv), présente un élément de contact (6) disposé sur un côté supérieur (11) pour injecter un courant (I) d'alimentation de l'élément à diode laser à géométrie en ruban et dont le côté supérieur (11) est délimité transversalement par rapport à la direction de propagation longitudinale (L) par des sillons (90) qui s'étendent d'une part le long de la direction de propagation longitudinale (L) et d'autre part en direction du substrat (1) sur lequel l'élément à diode laser à géométrie en ruban est constitué, lesquels sillons créent des flancs (9) du ruban laser (100), et dont des écrans de limitation de courant qui sont configurés comme régions oxydées s'étendent vers le ruban laser,
**caractérisé en ce que**
une zone (5; 5') d'absorption du rayonnement est formée dans la région des flancs (9), ce qui empêche très largement l'apparition de réflexions du rayonnement sur les flancs.

2. Elément à diode laser à géométrie en ruban selon la revendication 1, **caractérisé en ce que** la zone d'absorption (5) est configurée sous la forme d'une couche d'absorption disposée dans les sillons (90).

3. Elément à diode laser à géométrie en ruban selon l'une des revendications 1 et 2, **caractérisé en ce que** la zone d'absorption (5; 5') présente une intensité variable d'absorption dans une direction perpendiculaire à la direction de propagation longitudinale (L) et à la direction du courant (I).

4. Elément à diode laser à géométrie en ruban selon l'une des revendications 1 à 3, **caractérisé en ce que** la zone d'absorption (5') est créée par implantation d'ions dans la région des flancs (9) du ruban laser.

5. Elément à diode laser à géométrie en ruban selon l'une des revendications précédentes, **caractérisé en ce que** partant de la surface (11), les flancs (9) s'évasent sous un angle obtus (α).

6. Elément de diode laser à géométrie en ruban selon l'une des revendications précédentes, **caractérisé en ce que** la zone d'absorption (5; 5') est constituée de Si et/ou de Ge.
